# EUROPÄISCHE PATENTSCHRIFT

(11) **EP 3 532 356 B1**
(45) Veröffentlichungstag und Bekanntmachung des Hinweises auf die Patenterteilung: **15.07.2020**
(21) Anmeldenummer: 17793859.4
(22) Anmeldetag: 17.10.2017
(51) Int. Cl.: B60W 50/00, B60W 50/02, B60W 50/023, G01R 31/36, B60L 3/00

(54) **VERFAHREN ZUM ÜBERWACHEN EINES KRAFTFAHRZEUGS MIT AUTOMATISIERTER FAHRFUNKTION UND VORRICHTUNG ZUM DURCHFÜHREN DES VERFAHRENS**
METHOD FOR MONITORING A MOTOR VEHICLE WITH AUTOMATED DRIVING FUNCTION AND DEVICE FOR PERFORMING THE METHOD
PROCÉDÉ DE SURVEILLANCE D'UN VÉHICULE AUTOMOBILE AVEC UNE FONCTION DE CONDUITE AUTOMATISÉE ET DISPOSITIF POUR LA MISE EN OEUVRE DU PROCÉDÉ

(30) Priorität: 28.10.2016 DE 102016221334; 16.10.2017 DE 102017218446
(43) Veröffentlichungstag der Anmeldung: 04.09.2019
(73) Patentinhaber: Robert Bosch GmbH, 70442 Stuttgart (DE)
(72) Erfinder: LOHRMANN, Martin Andreas, 70176 Stuttgart (DE); MOTZ, Juergen, 71711 Steinheim An Der Murr (DE); MEISSNER, Marco, 70469 Stuttgart (DE); HEIDINGER, Frederic, 73728 Esslingen (DE); MUENZING, Patrick, 70734 Fellbach (DE); KOLLER, Oliver Dieter, 71384 Weinstadt (DE)
(86) Internationale Anmeldenummer: PCT/EP2017/076413
(87) Internationale Veröffentlichungsnummer: WO 2018/077658

(56) Entgegenhaltungen:
- DE-A1-102010 026 772
- DE-A1-102014 214 103
- US-A1- 2014 210 638

## Beschreibung

Die Erfindung betrifft ein Verfahren zum Überwachen eines Kraftfahrzeugs mit automatisierter Fahrfunktion und eine Vorrichtung zum Durchführen des Verfahrens. Bei dem Verfahren werden insbesondere sicherheitsrelevante Funktionen des Bordnetzes überwacht.

### Stand der Technik

Unter einem Fahrzeugbordnetz bzw. Bordnetz ist insbesondere im automotiven Einsatz die Gesamtheit aller elektrischen Komponenten in einem Kraftfahrzeug zu verstehen. Somit sind davon sowohl elektrische Verbraucher als auch Versorgungsquellen, wie bspw. Generatoren oder elektrische Speicher, z. B. Batterien, umfasst. Im Kraftfahrzeug ist darauf zu achten, dass elektrische Energie so verfügbar ist, dass das Kraftfahrzeug jederzeit gestartet werden kann und während des Betriebs eine ausreichende Stromversorgung sichergestellt ist. Aber auch im abgestellten Zustand sollen elektrische Verbraucher noch für einen angemessenen Zeitraum betreibbar sein, ohne dass ein nachfolgender Start beeinträchtigt wird.

Das Fahrzeugbordnetz hat die Aufgabe, die elektrischen Verbraucher mit Energie zu versorgen. Fällt die Energieversorgung aufgrund eines Fehlers bzw. Alterung im Bordnetz bzw. in einer Bordnetzkomponente in heutigen Fahrzeugen aus, so entfallen wichtige Funktionen, wie die Servolenkung. Da die Lenkfähigkeit des Fahrzeugs nicht beeinträchtigt sondern nur schwergängig wird, ist der Ausfall des Bordnetzes in heutigen in Serie befindlichen Fahrzeugen allgemein akzeptiert, da der Fahrer als Rückfallebene zur Verfügung steht.

Es ist jedoch zu beachten, dass aufgrund der zunehmenden Elektrifizierung von Aggregaten sowie der Einführung von neuen Fahrfunktionen höhere Anforderungen an die Sicherheit und Zuverlässigkeit der elektrischen Energieversorgung im Kraftfahrzeug resultieren.

Bei zukünftigen hochautomatisierten Fahrfunktionen, wie einem Autobahn-Piloten, werden dem Fahrer fahrfremde Tätigkeiten in begrenztem Maße erlaubt. Hieraus resultiert, dass bis zum Beenden der hochautomatisierten Fahrfunktion der menschliche Fahrer die Funktion als sensorische, regelungstechnische, mechanische und energetische Rückfallebene nur noch eingeschränkt wahrnehmen kann. Daher besitzt die elektrische Versorgung beim hochautomatisierten Fahren zur Gewährleistung der sensorischen, regelungstechnischen und aktuatorischen Rückfallebene eine bisher im Kfz nicht gekannte Sicherheitsrelevanz. Fehler bzw. Alterung im elektrischen Bordnetz müssen daher zuverlässig und möglichst vollständig im Sinne der Produktsicherheit erkannt werden.

Um den Ausfall von Komponenten prognostizieren zu können, wurden zuverlässigkeitstechnische Ansätze zur Überwachung von Fahrzeugkomponenten erarbeitet. Dazu werden die Bordnetz-Komponenten während des Betriebs überwacht und deren Schädigung ermittelt. Ein solches Verfahren ist bspw. in der Druckschrift DE 10 2013 203 661A1 beschrieben.

Bei einem zukünftigen automatisierten und auch autonomen Fahrbetrieb im Kraftfahrzeug steht der Fahrer nicht mehr, wie dies bekannt ist, als sensorische, regelungstechnische, mechanische und energetische Rückfallebene zur Verfügung. Das Fahrzeug übernimmt die Funktionen des Fahrers, wie z. B. die Umgebungserkennung, die Trajektorien-Planung und die Trajektorien-Umsetzung, die z. B. auch das Lenken und Bremsen umfassen.

Fällt die Energieversorgung der sicherheitsrelevanten Komponenten aus, ist das Fahrzeug durch die hoch-/ vollautomatisierte Funktion nicht mehr kontrollierbar, da alle vorstehend beschriebenen Funktionen, wie bspw. die Umgebungserkennung, sowie Trajektorien-Planung und -Umsetzung, nicht mehr zur Verfügung stehen. Dadurch ergeben sich aus Sicht der Produktsicherheit sehr hohe Anforderungen an das Bordnetz. Dies bedeutet ebenso, dass die Funktion des automatisierten bzw. autonomen Fahrens dem Nutzer nur dann zur Verfügung stehen darf, wenn das Bordnetz in einwandfreiem Zustand ist und in naher Zukunft auch bleibt.

Die Batterie bzw. die Batterien ist bzw. sind eine der wichtigsten Komponenten im Energiebordnetz, welche die Energieversorgung im Fahrzeug sicherstellen und Betriebsmodi wie Rekuperation, Segeln und Boosten ermöglichen. Durch diese besondere Stellung im Bordnetz muss die Analyse der Batterie erweitert werden.

Aus der Druckschrift DE 10 2012 209 627 A1 ist ein Verfahren zum Laden einer Batterie eines Fahrzeugs bekannt. Bei diesem wird für mindestens eine Batterie eines Bordnetzes eine Batteriemanagementfunktion und/oder eine Sicherheitsfunktion durchgeführt, wobei ein Batteriesensor verwendet wird.

Die Druckschrift DE 10 2008 042 121 A1 beschreibt ein Verfahren zum Überwachen eines Bordnetzes in einem Fahrzeug, bei dem ein Batteriesensor eingesetzt wird.

Aus der DE 10 2014 214 103 A1 ist eine Vorrichtung zur Versorgung zumindest eines Verbrauchers bekannt. Ein sicherheitsrelevanter, funktionstechnisch redundanter erster Verbraucher ist mit einem ersten Kanal verbunden, sowie ein weiterer, sicherheitsrelevanter, funktionstechnisch redundanter zweiter Verbraucher ist mit einem zweiten Kanal verbunden.

### Offenbarung der Erfindung

Vor diesem Hintergrund wird ein Verfahren gemäß Anspruch 1 vorgestellt. Ausführungsformen ergeben sich aus den abhängigen Ansprüchen und aus der Beschreibung.

Das Verfahren zum Überwachen eines Kraftfahrzeugs mit automatisierter Fahrfunktion dient insbesondere zum Überwachen und Kontrollieren bzw. Ansteuern von sicherheitsrelevanten Funktionen des Bordnetzes in Abhängigkeit eines Zustands einer Batterie in diesem Bordnetz. Dabei kann eine solche sicherheitsrelevante Funktion freigegeben oder gesperrt werden. Eine solche Funktion ist bspw. der Übergang in den sicheren Zustand im Fehlerfall. Das Kontrollieren bzw. Ansteuern einer sicherheitsrelevanten Funktion kann dabei ein Freigeben oder Sperren dieser Funktion bedeuten. Erfindungsgemäß sind unterschiedliche Betriebsweisen vorgesehen, das Kraftfahrzeug zum Stillstand zu bringen. Der jeweiligen Betriebsweise ist jeweils ein Lastprofil zugeordnet, das bei der Ansteuerung des Verbrauchers in dieser Betriebsweise üblicherweise auftritt. In Abhängigkeit von zumindest einem der Lastprofile wird zumindest eine Kenngröße des Energiespeichers prädiziert und in Abhängigkeit von der prädizierten Kenngröße des Energiespeichers die dem Lastprofil zugehörige Betriebsweise und/oder die automatisierte Fahrfunktionen freigegeben, gesperrt, verlassen oder beeinflusst. Damit können bereits rechtzeitig eventuell zukünftig auftretende Fehler bzw. unsichere Zustände des Bordnetzes vor ihrem Auftreten erkannt werden und schon vorher eine sichere Auswahl der geeigneten Betriebsweise vorgenommen werden.

In einer zweckmäßigen Weiterbildung sind zumindest zwei Energiespeicher vorgesehen wobei abhängig von dem Lastprofilkenngrößen für jeden der beiden Energiespeicher praktiziert werden und abhängig davon zugehörige Betriebsweisen und/oder automatisierte Fahrfunktionen freigegeben, gesperrt, verlassen oder beeinflusst werden. Zum einen wird eine redundante Versorgung von wichtigen Komponenten bzw. Funktionen ermöglicht. Durch die individuelle Berücksichtigung der jeweiligen Energiespeicher können die zulässigen Betriebsweisen genauer ermittelt werden. Damit erhöht sich die Betriebssicherheit der automatisierten Fahrfunktionen.

Im Rahmen des vorgestellten Verfahrens wird die Freigabe bestimmter Funktionen zur Erhaltung einer sicheren Betriebsweise bei Fahrzeugen mit automatisierten Fahrfunktionen vorgeschlagen. Diese Funktionalität bekommt gerade bei einem automatisierten Fahren Bedeutung, da der Fahrer fahrfremde Tätigkeiten ausüben darf und nicht als Rückfallebene zur Verfügung steht. Folglich ist das Wissen über den Zustand bzw. die Vorhersage des Zustands der Batterie aus Sicht der funktionalen Sicherheit und zur Bereitstellung zuverlässiger Systeme unerlässlich. Ein Beispiel für eine Funktion, bei der eine Freigabe bzw. Verhinderung implementiert werden kann, ist der Übergang in den sicheren Zustand, der im automatisierten Fahren besonders an Bedeutung gewinnt.

Damit ist eine Systemsteuerung bzw. System Control vorgesehen, die bzw. das eine gesamtheitliche Zustandsüberwachung bzw. Status Monitoring aller relevanten Komponenten bzw. Systeme im Fahrzeug durchführt. Aus Sicht der Produktsicherheit ist eine solche Einrichtung für sicherheitskritische neue Anwendungen mit veränderten Grundannahmen, wie z. B. automatisiertes Fahren, unbedingt erforderlich. Verschleißausfälle von Komponenten sind bekanntlich die Grundursache für einen Großteil der Bordnetzzustände, die im Kontext der neuen Anwendungsbereiche sicherheitsrelevant sind, daher müssen diese im Fahrzeug präventiv identifiziert und Gegenmaßnahmen eingeleitet werden. Da der Energiespeicher bzw. die Batterie eine der wichtigsten Komponenten im Energiebordnetz ist, werden in der Erfindung Maßnahmen zur präventiven Batterieanalyse vorgestellt, die zur Realisierung der neuen Anwendungen unerlässlich sind.

Erfindungsgemäß ist ein Verfahren zum Überwachen eines Bordnetzes in einem Kraftfahrzeug mit automatisierter Fahrfunktion (beispielsweise nach SAE-J3016, bzw. BaSt, bzw. NHTSA) vorgesehen, bei der die Fähigkeit einer oder mehrere Energiespeicher bzw. Batterien unter Berücksichtigung der aktuellen Randbedingungen (Alterung, Temperatur, SOC usw.) prädiziert wird, um das automatisierte Fahrzeug in einen sicheren Zustand zu bringen. In Abhängigkeit der prädizierten Kenngrößen werden erfindungsgemäß automatisierte Fahrfunktionen freigegeben, gesperrt, verlassen bzw. degradiert.

Besonders zweckmäßig werden sogenannte Safe-Stopp-Szenarien (Betriebsweisen, ein Fahrzeug zum Stillstand zu bringen) anhand des prädizierten Zustands des Energiespeichers überprüft und auf Grundlage dieser Überprüfung ein Safe-Stopp-Szenario ausgewählt, mit dem das Kraftfahrzeug in einen sicheren Zustand überführt wird.

Besonders zweckmäßig erfolgt zusätzlich eine Energiemanagement-Maßnahme zur Verbesserung der Bordnetzstabilität und/oder Degradierung der automatisierten Fahrfunktion. In einer zweckmäßigen Weiterbildung werden zusätzlich Fehler und deren Auswirkung auf den Zustand des Energiespeichers berücksichtigt. Besonders vorteilhaft erhält der Fahrer eine Warnung über den kritischen Zustand. Auch kann der Fahrer zur Übernahme der Fahrzeugsteuerung aufgefordert werden. In einer zweckmäßigen Weiterbildung wird das Lastprofil abhängig von dem Zustand des Bordnetzes, insbesondere einen Fehler und/oder einer Belastung des Bordnetzes und/oder einem Zustand der Last vorgegeben. Eine Vorrichtung kann dazu ausgebildet sein, eine Rückmeldung von einer Überwachungseinheit, beispielsweise einem Batteriesensor, an ein übergeordnetes Steuergerät zum Freigeben, Sperren, Verlassen bzw. Degradieren der automatisierten Fahrfunktionen zu geben. Alternativ kann eine Rückmeldung des übergeordneten Steuergeräts an die Überwachungseinheit betreffend der angepassten Belastungsprofile für die entsprechenden Safe-Stopp-Szenarien erfolgen.

Vorteile des vorgestellten Verfahrens und der beschriebenen Einrichtung, zumindest in einigen der Ausführungen, sind:
- Unterstützung bzw. Support für die Freigabe und Freigabeentscheidung für automatisierte Fahrfunktionen:
   Alterungseffekte in der Batterie führen zum Entzug der Freigabe bzw. zum Verlassen der Fahrfunktionen, wie z. B. automatisiertes Fahren, bzw. zum Entzug der Freigabe oder zum Verlassen bestimmter Betriebsmodi, z. B. Segeln, bzw. zum Übergang in den sicheren Zustand, um sicherheitskritische Zustände zu vermeiden.
- Zuverlässigkeitserhöhung durch adaptierte Fahrstrategien:
   Fahrsituationen, die im Betrieb zu einem starken Alterungsverhalten der Batterie führen, werden, falls aus Systemsicht möglich, vermieden.
- Verfügbarkeitserhöhung:
   Präventiver Batterietausch kann rechtzeitig vor einem unkontrollierten Batterieausfall, z. B. in regulären Wartungsintervallen, durchgeführt werden.
- Sicherheitsgewinn bei Übergabe vom automatisierten Fahrbetrieb in den manuellen Fahrbetrieb:
   Durch frühzeitiges Warnen vor einem Batterieausfall kann die Fahrzeugübergabe in einer für den Fahrer leichter beherrschbaren Situation durchgeführt werden.
- Zwingende Notwendigkeit, das Fahrzeug auch bei Ausfall von Komponenten ohne Eingriff eines Fahrers bei vollautomatisiertem Fahren in den sicheren Zustand zu bringen:
   Zeitgewinn bei der Einleitung der Rückfallstrategie durch frühzeitige Warnung, bzw. keine Freigabe der Fahrfunktionen bei sich anbahnendem Batterieausfall und Vermeidung eines ungewollten Bordnetzausfalls durch die Überprüfung, welches Safe-Stopp-Szenario aus Batteriesicht noch zulässig ist.
- Erhöhung der Zuverlässigkeit und der Sicherheit auch von nicht-automatisierten Fahrzeugen durch frühzeitiges Erkennen von anstehenden Ausfällen, wodurch auch "Liegenbleiber" auf Fahrspuren z. B. auf Autobahnen vermieden werden können.

Weitere Vorteile und Ausgestaltungen der Erfindung ergeben sich aus der Beschreibung und den beiliegenden Zeichnungen.

### Kurze Beschreibung der Zeichnungen

Figur 1 zeigt eine Ausführung eines Batteriesensors.
Figur 2 zeigt das Konzept einer Ausführung der Funktion eines Batteriesensors.
Figur 3 zeigt in einem Flussdiagramm eine Ausführung des vorgestellten Verfahrens.
Figur 4 zeigt in einem Flussdiagramm eine weitere Ausführung des vorgestellten Verfahrens.
Figur 5 zeigt unterschiedliche Lastprofile.

### Ausführungsformen der Erfindung

Die Erfindung ist anhand von Ausführungsformen in den Zeichnungen schematisch dargestellt und wird nachfolgend unter Bezugnahme auf die Zeichnungen ausführlich beschrieben.

Beispielhaft ist in dem Ausführungsbeispiel als möglicher Energiespeicher eine Batterie beschrieben. Alternativ können jedoch andere für diese Aufgabenstellung geeignete Energiespeicher beispielsweise auf induktiver oder kapazitiver Basis, Brennstoffzellen, Kondensatoren oder Ähnliches gleichermaßen Verwendung finden.

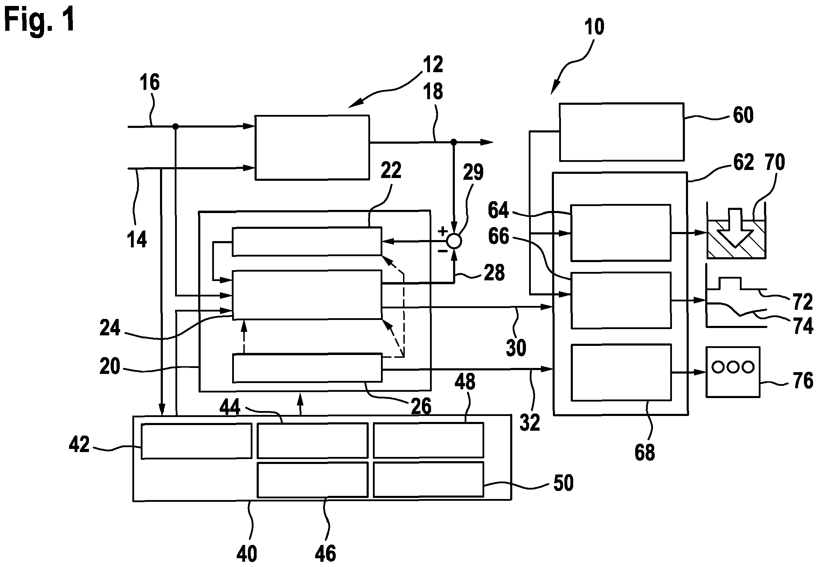

Figur 1 zeigt einen Batteriesensor, der insgesamt mit der Bezugsziffer 10 bezeichnet ist. Eingangsgrößen in eine Einheit 12, insbesondere eine Messeinheit, sind die Temperatur T 14 und der Strom I 16, Ausgangsgröße ist die Spannung U 18.

In einem Block 20 erfolgt die Abschätzung von Parametern und Zuständen. Hierin sind eine Rückkopplungseinheit 22, ein Batteriemodell 24 und eine Adaption 26 der Parameter vorgesehen. Es werden eine Variable û 28, Zustandsvariablen ^x 30 und Modellparamater ^p 32 ausgegeben.

Ein Knoten 29 dient dazu, das Batteriemodell 24 an die Batterie anzupassen. Der Strom I 16 geht direkt und die Temperatur T 14 geht indirekt in das Batteriemodell 24 ein. Dieses berechnet û 28 und gleicht dieses mit der realen Spannung U 18 ab. Bei Abweichungen wird das Batteriemodell 24 über die Rückkopplungseinheit 22 korrigiert.

Weiterhin ist ein Block 40 für Sub-Algorithmen bereitgestellt. Dieser umfasst ein Batterietemperaturmodell 42, eine Ruhespannung 44, eine Spitzenstrommessung 46, eine adaptive Startstromvorhersage 48 und eine Batteriegrößenerfassung 50.

Daneben sind Lastprofile 60 bereitgestellt, die in einen Block 62 mit Prädiktoren eingehen. Diese sind ein Ladungsprädiktor 64, ein Spannungsprädiktor 66 und ein Alterungsprädiktor 68. Ausgaben des Blocks 62 sind ein SOC 70, Verläufe von Strom 72 und Spannung 74 und ein SOH 76.

Der Batteriesensor 10 ermittelt somit den aktuellen SOC (State of Charge) 70 der Batterie und den aktuellen SOH 76 (State of Health, Kapazitätsverlust im Vergleich zum Ausgangszustand) der Batterie. Über die Prädiktoren 64, 66, 68 ist der Batteriesensor 10 in der Lage, den SOC 70 und den SOH 76 nach mehreren vorher definierten Belastungsszenarien vorherzusagen. Diese können jetzt auch auf automatisiertes Fahren bzw. auf den jeweiligen Anwendungsfall angepasst werden. Insbesondere sind die Prädiktoren 64, 66, 68 in der Lage, unter Rückgriff eines typischen Belastungsvorgangs (anhand bestimmter Lastprofile 141) einer zugehörigen Betriebsweise (SSL 1, SSL 2, SSL 3), ein Fahrzeug zum Stillstand zu bringen, zumindest eine bestimmte Kenngröße der Batterie 106, 110 zu prädizieren (mit Hilfe einer Simulation vorherzusagen). Es können unterschiedliche Betriebsweisen (SSL 1, SSL 2, SSL 3) vorgesehen sein, um das Fahrzeug zum Stillstand zu bringen und damit einen sicheren Betriebszustand des Kraftfahrzeugs (Safe Stop Level) zu erreichen. Jeder dieser unterschiedlichen Betriebsweisen (SSL 1, SSL 2, SSL 3) ist jeweils ein Lastprofil 141 zugeordnet. Bei der jeweiligen Belastung 141 wird der aktuelle Batteriezustand simuliert und dessen Auswirkungen auf die prädizierte Kenngröße der Batterie 106, 110 (wie beispielsweise SOC, SOH und den SOF (State of Function beschreibt die Leistungsfähigkeit der Batterie und gibt Auskunft darüber, mit welcher Leistung der Energiespeicher den Verbraucher versorgen kann)) zu ermitteln. Führt das Lastprofil 141 in der Simulation zur Unterschreitung bestimmter Grenzwerte durch die Kenngröße, wird die jeweilige mit dem simulierten Lastprofil 141 verknüpfte Betriebsweise SSL gesperrt.

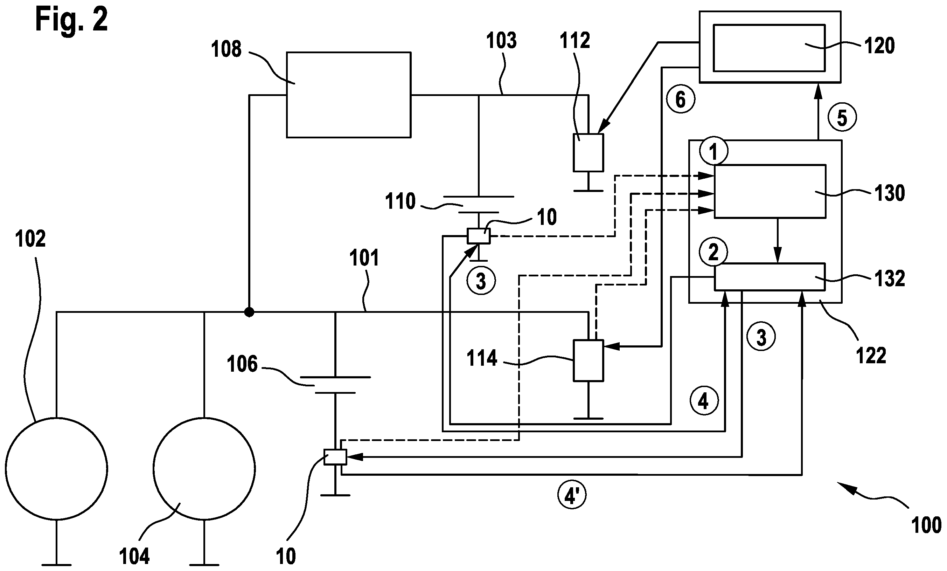

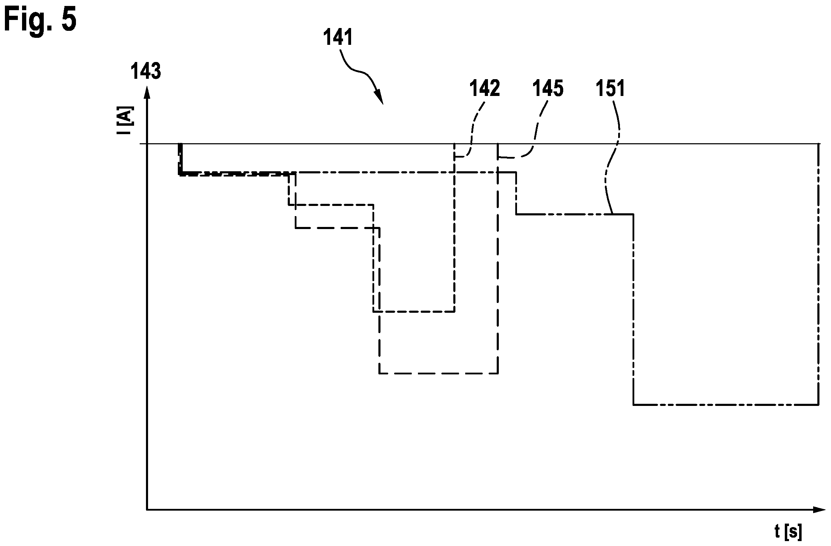

In Figur 2 ist eine Ausführung des Gesamtkonzepts unter Integration der Batteriesensor-Funktion dargestellt. Die Darstellung zeigt ein Bordnetz 100 mit einem Generator 102, einem Starter 104, einer ersten Batterie 106 mit einem zugeordneten Batteriesensor 10, einem Gleichspannungswandler 108, einer zweiten Batterie 110 mit zugeordnetem weiteren Batteriesensor 10, einem ersten Verbraucher 112 und einem zweiten Verbraucher 114. Die dargestellten Verbraucher 112 und 114 stehen jeweils stellvertretend für einen oder mehrere Verbraucher. Beispielhaft wird ein zweiter Verbraucher 114 von einem ersten Kanal 101, der mit der ersten Batterie 106 verbunden ist, gespeist. Der erste Verbraucher 112 wird von einem zweiten Kanal 103, der mit der zweiten Batterie 110 verbunden ist, gespeist. Der eine Batteriesensor 10 überwacht die eine Batterie 106. Der weitere Batteriesensor 10 überwacht die weitere Batterie 110. Weiterhin sind eine Systemsteuerung 120 und ein Sicherheitsmanagement 122 mit einer Systemdiagnose 130 und einer Fehleridentifikation 132 vorgesehen. Der oder die Batteriesensoren 10 können beispielhaft so ausgebildet sein wie in Figur 1 dargestellt. Gerade für das automatisierte Fahren werden unterschiedliche, vorher in Form von Lastprofilen 141 definierte Belastungsszenarien unterschiedlicher Betriebsweisen SSL, die zum sicheren Anhalten des Fahrzeugs notwendig sind, verwendet. Solche unterschiedlichen Belastungsszenarien sind beispielhaft für drei unterschiedliche Betriebsweisen SSL 1, SSL 2, SSL 3, einen sicheren Stopp des Fahrzeugs herbeizuführen, in Figur 5 gezeigt wie nachfolgend näher ausgeführt.

Auf Basis der im Batteriesensor 10 vorhandenen Algorithmen werden Freigaben beispielsweise im Batteriesensor 10 oder aber in einem sonstigen Steuergerät (beispielsweise in der Systemsteuerung 120 oder dem Sicherheitsmanagement 122, in demjenigen für die Trajektorienplanung 155 oder einem sonstigen Fahrzeug-Steuergerät) implementiert. Dabei wird der aktuelle Zustand, d. h. SOC, SOH, Alterung usw., der Batterie 106, 110 und deren Rahmenbedingungen, wie bspw. die Temperatur 14, bei der Prognose des zukünftigen Zustandes in Form einer entsprechenden Kenngröße, bspw. nach Übergang in den sicheren Zustand, berücksichtigt. Dazu werden bspw. die Belastungs-, Strom-, Spannungs- und/oder Temperaturprofile der Szenarien im Batteriesensor 10 hinterlegt und das Verhalten während bzw. nach Durchführung der Szenarien simuliert. Im Ausführungsbeispiel sind beispielhaft als Lastprofile 141 unterschiedliche Stromprofile verwendet. Als Ergebnis der Simulation unter Verwendung des Batteriemodells 24 erhält man die prädizierte Kenngröße bzw. Kenngrößen SOC, SOF, SOH, Batteriespannung U usw. der Batterie 106,110 während bzw. nach der betrachteten Betriebsweise SSL 1, SSL 2, SSL 3. Diese prädizierte Kenngröße an der Batterie 106, 110 wird mit zumindest einem vorgegebenen Grenzwert, der eine Mindestanforderung der benötigten Komponente bzw. Verbrauchers 112, 114 (unter Berücksichtigung des Kabelbaumwiderstands des Bordnetzes 100) verglichen und die zugehörige Betriebsweise SSL 1, SSL 2, SSL 3 freigegeben oder gesperrt (bei Unterschreiten der Mindestanforderungen). Alternativ kann die entsprechende Betriebsweise SSL angepasst werden. Dies könnte beispielsweise dadurch erfolgen, dass die Fahrgeschwindigkeit geändert wird oder ein langsameres Bremsen erfolgt. Damit wird das zugehörige Lastprofil 141 so geändert, dass die Kenngröße nicht mehr den zulässigen Grenzwert unterschreitet.
1. Freigabe verschiedener Betriebsweisen SSL 1, SSL 2, SSL 3, das Fahrzeug zum Stillstand zu bringen bzw. in den sicheren Zustand zu überführen:
   Bei dieser Funktion werden die verschiedenen Betriebsweisen SSL , ggf. mit EEM-Maßnahmen (EEM: Energiemanagement), wie bspw. Lastzu- und/oder abschaltungen, im Batteriesensor 10 bspw. als Lastprofile 141 (Belastungs-, Strom-, Spannungs- und/oder Temperaturprofile) eingeprägt. Mithilfe der Prädiktoren 64, 66, 68 wird die Kenngröße (bspw. SOC, SOF, SOH, Batteriespannung U) der Batterie 106,110 während bzw. nach dem betrachteten Szenario ermittelt. Werden gewisse Werte, z. B. festgelegt auf Basis der Spannungsgrenzen der sicherheitsrelevanten Verbraucher 112, 114, gegebenenfalls unter Berücksichtigung der Verluste der zugrunde gelegten Topologie, unterschritten, wird die jeweilige Betriebsweise SSL gesperrt.
2. Freigabe verschiedener Betriebsweisen SSL, ggf. mit EEM-Maßnahmen, und Fehler:
   Bei dieser Funktion werden Fehler, die im Bordnetz 100 auftreten können, in Kombination mit den verschiedenen Betriebsweisen SSL ggf. mit EEM-Maßnahmen, wie bspw. Lastzu- und/oder abschaltungen, im Batteriesensor 10 bspw. als Belastungs-, Strom-, Spannungs- und/oder Temperaturprofile eingeprägt. Mithilfe der Prädiktoren 64, 66, 68 werden Kenngrößen SOC, SOF, SOH, Batteriespannung U der Batterie während bzw. nach dem betrachteten Szenario ermittelt bzw. prädiziert. Werden gewisse Werte, z. B. festgelegt auf Basis der Spannungsgrenzen der sicherheitsrelevanten Verbraucher unter Berücksichtigung der Verluste der zugrunde gelegten Topologie, unterschritten, wird die jeweilige Kombination von berücksichtigtem Fehler bei betrachteter Betriebsweise SSL gesperrt.

Als Verbraucher 112, 114, kommen solche in Betracht, die notwendig sind, um das Fahrzeug in einen sicheren Betriebszustand zu überführen, insbesondere zur Durchführung der oben beschriebenen Betriebsweisen SSL 1, SSL 2, SSL 3 unter Verwendung der entsprechenden Lastprofile 142, 145, 151. Bei diesen notwendigen Verbrauchern 112, 114 handelt es sich beispielsweise um Aktuatoren zur Aktivierung des Bremssystems 147 und/oder der Lenkung 149 und/oder um eine Umfeldsensorik 153 und/oder eine Trajektorienplanung 155.

Beim automatisierten Fahren werden insbesondere redundante Energiebordnetze eingesetzt. Dies kommt in Figur 2 darin zum Ausdruck, dass zwei Teilnetze mit zwei unabhängig voneinander versorgbaren Kanälen 101, 103 vorgesehen sind. Beispielsweise sind die beiden Kanäle 101, 103 durch einen Gleichspannungswandler 108 miteinander verbunden, um einen Energieaustausch zu ermöglichen. Jedes dieser Teilnetze bzw. Kanäle 101, 103 weist jeweils einen Energiespeicher, bspw. eine Batterie 106, 110 auf, die den bzw. die zugehörigen Verbraucher 112 bzw. 114 mit Energie versorgen kann. Bevorzugt sind Verbraucher redundant ausgeführt, die für eine bestimmte Fahrfunktionen notwendig sind, beispielsweise das Bremssystem 147 und/oder die Lenkung 149 und/oder die Umfeldsensorik 153 und/oder die Trajektorienplanung 155. So kann das Bremssystem 147 zumindest zwei Komponenten (beispielsweise ein ESP (Electric Stability Program), einen sog. iBooster (ein System zur elektromechanischen Bremsdruckerzeugung)) umfassen, die von den unterschiedlichen Kanälen 101, 103 versorgt werden. Damit wird sichergestellt, dass bei Ausfall eines Kanals 101, 103 ein sicheres Abbremsen des Fahrzeugs weiterhin möglich bleibt. Auch das Lenksystem 149 weist somit zwei redundante Komponenten auf, die jeweils von den unterschiedlichen Kanälen 101, 103 versorgt werden. Ebenfalls sind Bedien- Schnittstellen vorgesehen, die von den beiden Kanälen 101,103 jeweils versorgt werden. Weiterhin sind Sensoren und Recheneinheiten vorgesehen zur Erfassung der Umfeldsensorik und Berechnung der Trajektorien oder sonstigen Eingriffe zum gezielten Stillsetzen des Fahrzeugs. Diese Sensoren und Recheneinheiten sind ebenfalls redundant ausgebildet und werden durch unterschiedliche Kanäle 101,103 mit Energie versorgt.

Kommt es in einem der Teilsysteme des Energiebordnetzes zu einem Fehler, muss das Fahrzeug selbstständig einen sicheren Zustand erreichen. Dazu muss die Fähigkeit der Batterie 106, 110 des fehlerfreien Teilsystems sicherstellen, das Fahrzeug in den sicheren Zustand zu bringen. Zur Überwachung der Batterie 106, 110 ist der Batteriesensor 10 eingesetzt. Erkennt der Batteriesensor 10, dass eine Batterie 106,110 den Übergang in den sicheren Zustand nicht mehr sicherstellen kann, muss dies erkannt und an ein übergeordnetes Steuergerät wie beispielsweise das Systemsteuergerät 120 bzw. des Sicherheitsmanagement 122 weitergeleitet werden. Aufgrund der Information wird die entsprechende Fahrfunktion gesperrt oder verlassen oder degradiert.

Ein möglicher Ablauf ist in Figur 2 mit eingetragenen Ziffern verdeutlicht und wie folgt:
1. Der Batteriesensor 10 (EBS) und/oder andere Sensoren bzw. Komponenten liefern physikalische Zustandsgrößen an die Systemdiagnose 130 des Sicherheitsmanagements 122, das Teil der Systemsteuerung 120 sein kann.
2. Durch Plausibilisierung der physikalischen Kenngrößen werden Fehler erkannt.
   Alternativ: Fehler wird von der Komponente selbst erkannt und an das Sicherheitsmanagement 122 gemeldet.
3. Das Sicherheitsmanagement 122 meldet den Fehler an den Batteriesensor 10.
4. Der bzw. die Batteriesensoren 10 analysieren, welche Betriebsweisen SSL unter diesen Voraussetzungen noch möglich sind und melden diese Betriebsweisen SSL für jede Batterie 106, 110 an das Sicherheitsmanagement 122.
5. Das Sicherheitsmanagement 122 führt die Informationen der Batteriesensoren 10 und der anderen Komponenten zusammen und übergibt der Systemsteuerung 120 die noch fahrbaren Betriebsweisen SSL.
6. Die Systemsteuerung 120 leitet den Übergang in den sicheren Zustand durch eine als zulässig erkannte Betriebsweise SSL durch entsprechende Ansteuerung der Aktoren ein, wenn bestimmte Bedingungen (beispielsweise erkannte Fehler) vorliegen.

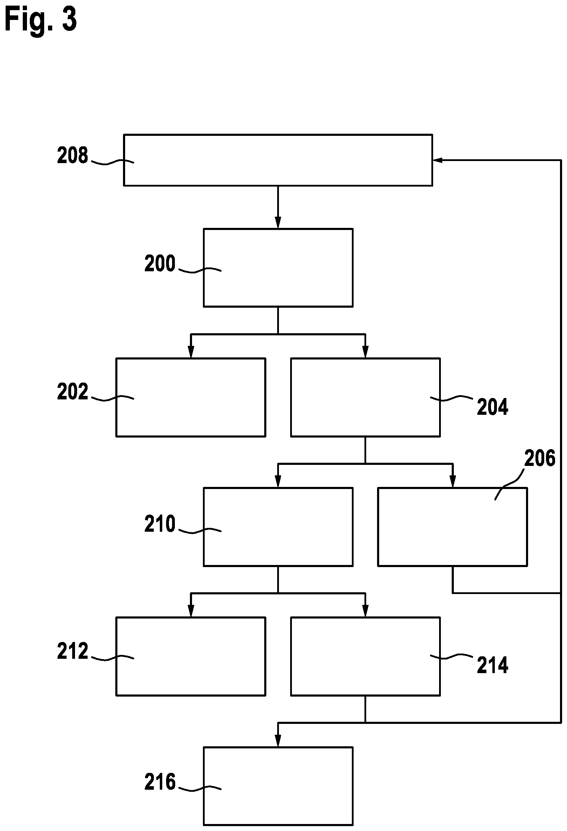

Ein möglicher Ablauf zur Freigabe von bestimmten Betriebsweisen SSL (Safe-Stopp-Levels, d. h. Übergänge in den sicheren Zustand), ist in Figur 3 dargestellt. In einem ersten Schritt 200 wird überprüft, ob die jeweilige Betriebsweise SSL bzw. Safe-Stopp-Szenario nie zu einem Ausfall führt. Ist dies wahr, so wird in einem Schritt 202 diese Betriebsweise SSL bzw. Safe-Stopp-Szenario ohne EEM-Maßnahme gesetzt. Ist dies falsch, so wird in einem Schritt 204 überprüft, ob diese Betriebsweise SSL bzw. Safe-Stopp-Szenario immer zu einem Ausfall führt. Ist dies wahr, so erfolgt eine Schleife 206 mit einem nächsten SSL bzw. Safe-Stopp-Szenario und eine Schleife 208 über SSL bzw. Safe-Stopp-Szenarien, beginnend bei einem kritischen Zustand. Dann beginnt der Ablauf wieder mit dem Schritt 200.

Ergibt die Überprüfung in Schritt 204 ein falsch, so wird in Schritt 210 überprüft, ob die Betriebsweise SSL bei hoher Last zum Ausfall führt, nicht jedoch bei niedriger Last. Ergibt die Überprüfung ein wahr, so werden in einem Schritt 212 diese Betriebsweise SSL bzw. Safe-Stopp-Szenario und eine EEM-Maßnahme, bspw. eine Lastabschaltung, gesetzt. Ergibt die Überprüfung in Schritt 210 falsch, so wird in einem Schritt 214 überprüft, ob die Betriebsweise SSL bei niedriger Last zum Ausfall und nicht bei hoher Last führt. Ergibt dies wahr, so werden in einem Schritt 216 diese Betriebsweise SSL Safe-Stopp-Szenario und eine EEM-Maßnahme, bspw. eine Lastzuschaltung, gesetzt. Ergibt die Überprüfung in Schritt 214 ein falsch, so wird die nächste Betriebsweise SSL2 bzw. Safe-Stopp-Szenario überprüft und es erfolgt ein Sprung zu Schritt 208.

Bei Ausführung des vorgestellten Verfahrens wird in Ausgestaltung bei der für den Fahrer "angenehmsten" Betriebsweise SSL begonnen. Dazu werden die zugehörigen Lastprofile 141 (Belastungs-, Strom-, Spannungs- und/oder Temperaturprofile, ggf. mit einer EEM-Maßnahme) im Prädiktor 62, 64, 66, 68 des Batteriesensors 10 eingeprägt. Solche Belastungsprofile 141 sind beispielhaft in Figur 5 für drei mögliche Betriebsweisen SSL 1, SSL 2, SSL 3 dargestellt. Der Prädiktor 62, 64, 66, 68 ermittelt aus den jeweiligen Lastprofilen 141, 142, 145, 151 den zu erwartenden (prädizierten) Verlauf der Kenngröße des Batteriezustands und gegebenenfalls weiterer wichtiger Kenngrößen. Beispiele dieser Kenngrößen sind der SOC, SOF, SOH und/oder die Spannung an der Batterie 106, 110. Über den Verlauf bzw. am Ende der Simulation werden die simulierten Kenngrößen mit Grenzwerten verglichen und die mit dem jeweiligen Lastprofil 141, 142, 145, 151, das der Simulation zu Grunde lag, verknüpfte Betriebsweise SSL1, SSL 2, SSL 3 freigegeben oder nicht. Wird eine Betriebsweise SSL nicht freigegeben, wird die nächste Betriebsweise 2 SSL für die Simulation mit dem zugehörigen Lastprofil 145 gewählt. Dies geschieht so lange, bis eine mögliche Betriebsweise SSL gefunden wurde, bzw. alle möglichen Betriebsweisen SSL ausprobiert wurden. Die Übergabe der Analyse-Ergebnisse findet z. B. an ein übergeordnetes Steuergerät in Form eines Freigabevektors statt, welche Betriebsweisen SSL jeweils ein sicheres Stillsetzen des Fahrzeugs ermöglichen.

Zusätzlich zu dem vorstehend vorgestellten Vorgehen können Fehler und deren Auswirkungen auf den Verlauf der Kenngröße desBatteriezustands bzw. den Verlauf der Batteriespannung bei der Simulation mit den jeweiligen Lastprofilen 141, 142, 145, 151 berücksichtigt werden. Hierbei lassen sich zwei Möglichkeiten unterschieden:

### 1. Möglichkeit:

Es werden vorsorglich jederzeit alle Fehler bei der Simulation nach dem vorstehend ausgeführten Vorgehen zusätzlich zu den Betriebsweisen SSL und der EEM-Maßnahme eingeprägt. Es werden die fahrbaren Betriebsweisen SSL in Kombination mit dem betrachteten Fehler ermittelt und z. B. mittels Vektor an ein übergeordnetes Steuergerät übergeben.

Von Vorteil dabei ist, dass die Informationen, welche Betriebsweise SSL in welchem Fehlerfall fahrbar sind, dauerhaft vorhanden sind. Zu beachten dabei ist, dass hierfür eine dauerhaft hohe Rechenleistung erforderlich ist.

### Möglichkeit 2:

Im Bordnetz 100 wird ein Fehler erkannt und es wird nach dem vorstehend dargestellten Vorgehen unter zusätzlicher Einprägung des erkannten Fehlers überprüft, welche Betriebsweise SSL bei dieser Kombination aus Fehler und SSL und EEM-Maßnahme noch fahrbar ist.

Von Vorteil ist, dass nur der relevante Fehler simuliert wird. Daher kann die Rechenleistung optimal genutzt werden. Zu beachten hierbei ist, dass die Berechnung erst stattfindet, wenn der Fehler schon eingetreten ist. Dies ist insbesondere bei zeitkritischen Anwendungen zu beachten.

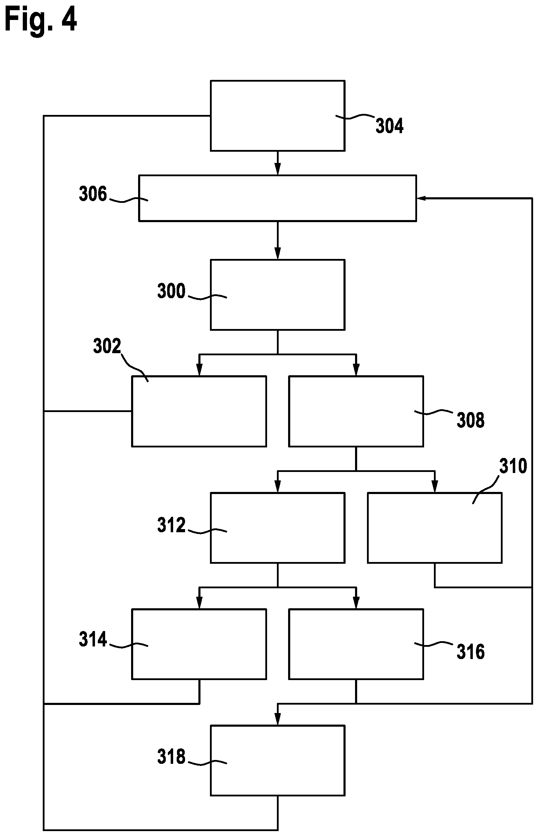

In Figur 4 ist ein möglicher Ablauf zur Ermittlung einer fahrbaren Betriebsweise SSL dargestellt. In einem ersten Schritt 300 wird überprüft, ob die Kombination aus Fehler und betrachteter Betriebsweise SSL nie zum Ausfall führt. Ist dies der Fall, so wird in einem Schritt 302 diese Betriebsweise SSL ohne EEM-Maßnahme gesetzt. Es wird dann der nächste Fehler geprüft in einer Schleife 304 über alle Fehler und einer Schleife 306 über mögliche Betriebsweisen SSL bzw. Safe-Stopp-Szenarien, beginnend bei einem kritischen Zustand.

Ergibt die Überprüfung in Schritt 300 ein falsch, so wird in einem Schritt 308 überprüft, ob die Kombination aus Fehler und Betriebsweise SSL immer zum Ausfall führt. Ist dies der Fall, so erfolgt eine Schleife 310 mit der nächsten Betriebsweise SSL und ein Sprung zur Schleife 306. Ergibt die Überprüfung in Schritt 308 ein wahr, so wird in einem Schritt 312 überprüft, ob die Kombination aus Fehler und dieser Betriebsweise SSL bei hoher Last zum Ausfall führt und bei niedriger Last nicht. Ist dies der Fall, so werden in einem Schritt 314 diese Betriebsweise SSL und eine EEM-Maßnahme, wie bspw. eine Lastabschaltung, gesetzt. Dann wird der nächste Fehler überprüft und es erfolgt ein Sprung zu Schleife 304. Ergibt die Überprüfung in Schritt 312 ein falsch, so wird in einem Schritt 316 überprüft, ob die Kombination aus Fehler und Betriebsweise SSL bei niedriger Last zum Ausfall führt und bei hoher Last nicht. Ist dies der Fall, so werden in einem Schritt 318 die entsprechende Betriebsweise SSL gesetzt und eine EEM-Maßnahme, bspw. eine Lastzuschaltung, gesetzt. Ist dies nicht der Fall, so wird die nächste Betriebsweise SSL geprüft und es erfolgt ein Sprung zu Schleife 306.

Beispielhaft sind nun drei Lastprofile 142, 145, 151 dreier unterschiedlicher Betriebsweisen SSL 1, SSL2, SSL3, ein Fahrzeug in den sicheren Zustand zu überführen, in Figur 5 gezeigt. In einem ersten Lastprofil 142 einer ersten Betriebsweise SSL1 in den sicheren Zustand erfolgt ein Nothalt durch eine reine Bremsung des Fahrzeugs ohne Lenkmanöver. So kann beispielsweise ein langsamer Aufbau des Bremsdrucks für geringe Verzögerung und halten in der Spur erfolgen. Diese erste Betriebsweise SSL1 benötigt aufgrund der kurzen Dauer wenig Energie und wenig elektrische Leistung, da keine dynamischen Fahr-Manöver gefahren werden.

Typischerweise handelt es sich um ein vereinfachtes Lastprofil 141, insbesondere ein Stromprofil bei aktuell gemessener Temperatur 14 und aktuellem Batteriezustand, das die maximal auftretende Belastung während dieses Fahrmanövers widerspiegelt. Beispielsweise ist das Lastprofil 141 in drei diskreten Stufen bestehend aus unterschiedlichen Lastströmen und Belastungsdauern gegliedert. In einer ersten Stufe weist das Lastprofil einen Grundlaststrom für eine bestimmte Dauer dt1 auf. Für eine bestimmte weitere Dauer dt2 (beispielsweise 5 s) erhöht sich der Strom des Lastprofils auf einen Aktuatorstrom (beispielsweise 50 A). Daran anschließend kann ein Spitzenstrom (beispielsweise 95 A) für eine weitere Dauer dt2 (beispielsweise 50 ms) fließen und damit das Lastprofil beenden.

Ein entsprechendes Lastprofil 142 eines ersten Übergangs SSL1 in den sicheren Zustand des Fahrzeugs ist in Figur 5 gezeigt. Das Lastprofil 142 ist beispielsweise in Form eines zeitlichen Verlaufs des Laststroms 143 aufgetragen. Bei dem Ausführungsbeispiel gemäß Figur 5 zeichnet sich das Lastprofil 142 durch eine stufenweise Aktivierung der Bremse 147 mit zugehörigem Laststrom aus. Beispielsweise erfolgt die Aktivierung 3-stufig. Nach relativ kurzer Zeit kommt das Fahrzeug zum Stehen, sodass zu diesem Zeitpunkt keine weitere Aktivierung des Bremssystems 147 erforderlich ist.

In einer zweiten Betriebsweise SSL2 erfolgt ein Nothalt des Fahrzeugs in der Spur. Dies geht einher mit einer Aktivierung sowohl des Bremssystems 147 wie auch der Lenkung 149. Beispielsweise erfolgt ein schneller Druckaufbau, eine ABS-Regelung sowie ein Halten in der Spur. Die Dauer des Manövers ist relativ kurz, aber es wird Energie für die Bremsdruck-Modulation benötigt. Weiterhin treten durch die Druck-Modulation im ESP Stromspitzen auf, bei denen die Batterie 106, 110 kurzfristig eine hohe Leistung bereitstellen muss. Dies äußert sich in dem dargestellten weiteren Lastprofil 145, das der zweiten Betriebsweise SSL2 zugeordnet ist. Im Ausführungsbeispiel gemäß Figur 5 ergibt sich ein höherer Laststrom 143 als bei reinem Bremsen gemäß dem ersten Lastprofil 142. Beispielhaft dauert es auch länger, bis das Fahrzeug anhält.

In einem dritten Übergang in den sicheren Zustand SSL3 erfolgt beispielsweise das Anhalten des Fahrzeugs am Standstreifen bzw. auf der rechten Spur. Hierzu muss die Lenkung 149 gemäß einer Trajektorienplanung 151, die in Abhängigkeit von einer Umfeldsensorik 153 die entsprechenden Trajektorien zum Erreichen der rechten Spur bzw. des Standstreifens ermittelt, angesteuert werden. Parallel erfolgt eine entsprechende Aktivierung des Bremssystems 147. Dieser Vorgang dauert gemäß einem der dritten Betriebsweise SSL3 zugeordnetem dritten Lastprofil 151 entsprechend länger. Der Laststrom 143 ist größer. Der entsprechende Energieinhalt zur Durchführung des dritten Übergangs 151 ist ebenfalls größer als bei den beiden vorangehenden Lastprofilen 142, 145.

Es sei erwähnt, dass die beschriebenen möglichen Betriebsweisen SSL1, SSL2, SSL3 mit jeweils zugeordneten Lastprofilen 142, 145, 151 zum Erreichen eines sicheren Zustands des Fahrzeugs lediglich beispielhaft genannt sind. Alternativ wären auch weitere Betriebsweisen denkbar wie beispielsweise ein Halten des Fahrzeugs erst beim nächsten Rastplatz oder der nächsten Werkstatt oder ähnliches. Die entsprechenden Lastprofile 141 wären entsprechend anzupassen. Die sich anschließende Simulation einer Kenngröße des Batteriezustands anhand der unterschiedlichen Lastprofile 141 würde jedoch entsprechend durchgeführt werden.

Basierend auf den unterschiedlichen Lastprofilen 142, 145, 151 wird eine Simulation durchgeführt unter Verwendung des beispielsweise im Batteriesensor 10 hinterlegten Batteriemodells 28 für den jeweiligen Energiespeicher. Das Batteriemodell 28 könnte hierzu auf einem elektrischen Ersatzschaltbild des Energiespeichers beruhen, beispielsweise unter geeigneter Verwendung eines RC-Netzwerks, beispielsweise durch entsprechende digitale Signalverarbeitung realisiert. Das Ergebnis der Simulation ist beispielsweise eine Minimalspannung, die während des zugehörigen Manövers an der Batterie 106, 110 auftreten kann. Die Minimalspannung an der Batterie 106, 110 wird mit den Mindestanforderungen der benötigten Komponenten bzw. Verbraucher 112, 114 bzw. Bremssystem 147, Lenkung 149, Umfeldsensorik 153, Trajektorienplanung 155, (gegebenenfalls unter Berücksichtigung des Kabelbaumwiderstands) verglichen. Bei Unterschreitung der Mindestanforderungen für die entsprechende Fahrfunktion wird diese gesperrt oder verlassen bzw. die Fahrstrategie entsprechend angepasst.

Prinzipiell geht es darum, vor jeder Freigabe für automatisiertes Fahren die beschriebene Simulation durchzuführen, bei der unter Berücksichtigung verschiedener Eingangsparameter (Temperatur, SOC, Grundlast, ggfs. Fehler usw.) ermittelt wird, ob zumindest eine Betriebsweise SSL zur Verfügung steht, um das Fahrzeug im autonomen Betrieb im Notfall wieder in einen sicheren Zustand zu überführen.

Alternativ oder ergänzend kann diese Prädiktion zyklisch während des autonomen Betriebsmodus erfolgen. Falls z.B. ein Fahren an den Fahrbahnrand nicht mehr möglich ist, bietet der Algorithmus die Information, ob stattdessen zumindest ein Halten in der Spur von der Batterie 106, 110 ermöglicht werden kann oder ein sofortiger Not-Stopp eingeleitet werden muss.

In dem Ausführungsbeispiel gemäß Figur 2 sind zwei Kanäle 101,103 vorgesehen, von denen sicherheitsrelevante Verbraucher 112, 114 versorgt werden. Die oben beschriebene Freigabe verschiedener Betriebsweisen SSL 1, SSL 2, SSL 3 wird nun für jeden Kanal 101, 103 bzw. für jede der in diesen Kanälen 101, 103 angeordneten Batterien 106, 110 durchgeführt. So erfolgt die Prädiktion der Kenngröße abhängig von den verschiedenen Betriebsweisen SSL für die erste Batterie 106 bzw. den ersten Kanal 101 durch den Batteriesensor 10, der den Batteriezustand der ersten Batterie 106 ermittelt. Somit werden bestimmte Betriebsweisen SSL 1, SSL 2, SSL 3 für den ersten Kanal 101 freigegeben oder gesperrt. Diese Information wird wie bereits beschrieben dem Sicherheitsmanagement 122 mitgeteilt. Entsprechend erfolgt die Prädiktion der Kenngröße für die weitere Batterie 110 durch denjenigen Batteriesensor 10, der den Batteriezustand der weiteren Batterie 110 ermittelt. Entsprechend werden die Betriebsweisen SSL 1, SSL 2, SSL 3 für den weiteren Kanal 103 freigegeben oder gesperrt. Auch diese Information wird dem Sicherheitsmanagement 122 mitgeteilt. Somit stehen also für beide Kanäle 101,103 die Informationen hinsichtlich Freigabe bzw. Sperrung für die jeweiligen Betriebsweisen SSL zur Verfügung. Liegt nun beispielsweise ein Fehler im ersten Kanal 101 vor, so wählt die Systemsteuerung 120 die geeignete freigegebene Betriebsweise SSL für den weiteren Kanal 103 aus. Die Systemsteuerung 120 steuert entsprechend die bzw. den vom weiteren Kanal 103 gespeisten Verbraucher 112 zur Erzielung der freigegebenen Betriebsweise SSL an.

Das vorgestellte Verfahren ist insbesondere bei Fahrzeugen geeignet, in denen das Bordnetz 100 eine hohe Sicherheitsrelevanz besitzt. Dies ist bspw. bei Fahrzeugen mit automatisierten Fahrfunktionen der Fall.

## Patentansprüche

1. Verfahren zum Überwachen eines Kraftfahrzeugs mit automatisierter Fahrfunktion, mit unterschiedlichen Betriebsweisen (SSL1, SSL2, SSL3), das Kraftfahrzeug zum Stillstand zu bringen, wobei zumindest ein Energiespeicher (106, 110), insbesondere eine Batterie, zumindest einen Verbraucher versorgt (112, 114), der das Fahrzeug zum Stillstand bringen kann, **dadurch gekennzeichnet, dass** der jeweiligen Betriebsweise (SSL1, SSL2, SSL3) jeweils ein Lastprofil (141, 142, 145, 151) zugeordnet ist, das bei einer Ansteuerung des Verbrauchers (114, 116) in dieser Betriebsweise (SSL1, SSL2, SSL3) üblicher Weise auftritt und, dass zumindest eine Kenngröße des Energiespeichers (106, 110) prädiziert wird in Abhängigkeit von zumindest einem der Lastprofile (141, 142, 145, 151), und in Abhängigkeit der von der prädizierten Kenngröße des Energiespeichers (106, 110) die dem Lastprofil (141, 142, 145, 151) zugehörige Betriebsweise (SSL1, SSL2, SSL3) und/oder die automatisierte Fahrfunktion freigegeben, gesperrt, verlassen oder beeinflusst wird.

2. Verfahren nach Anspruch 1, **dadurch gekennzeichnet, dass** zumindest zwei Energiespeicher (106, 110), insbesondere Batterien, vorgesehen sind zur insbesondere redundanten Versorgung des Verbrauchers (112, 114) und/oder zur Versorgung eines weiteren Verbrauchers (112, 114), der das Fahrzeug zum Stillstand bringen kann, und dass abhängig von dem Lastprofil (141, 142, 145, 151) Kenngrößen für jeden der beiden Energiespeicher (106, 110) prädiziert werden, wobei die zugehörige Betriebsweise (SSL1, SSL2, SSL3) und/oder automatisierte Fahrfunktion abhängig von den Kenngrößen freigegeben, gesperrt, verlassen oder beeinflusst werden.

3. Verfahren nach einem der vorhergehenden Ansprüche, **dadurch gekennzeichnet, dass** das Lastprofil (141, 142, 145, 151) abhängig von dem Zustand des Bordnetzes (100), insbesondere einem Fehler und/oder einer Belastung des Bordnetzes (100), und/oder einem Zustand der Last (112, 114) vorgegeben wird.

4. Verfahren nach einem der vorhergehenden Ansprüche, **dadurch gekennzeichnet, dass** die Kenngröße des Energiespeichers (106, 110) abhängig von einem Modell (24) des Energiespeichers (106, 110), das vorzugsweise in einem Batteriesensor (10) hinterlegt ist, ermittelt wird.

5. Verfahren nach einem der vorhergehenden Ansprüche, **dadurch gekennzeichnet, dass** eine Kenngröße eines weiteren Energiespeichers (106, 110) abhängig von einem Modell (24) des weiteren Energiespeichers (106, 110) prädiziert wird und in Abhängigkeit von der prädizierten Kenngröße des weiteren Energiespeichers (106, 110) die dem Lastprofil (141, 142, 145, 151) zugehörige Betriebsweise (SSL1, SSL2, SSL3) und/oder die automatisierte Fahrfunktion freigegeben, gesperrt, verlassen oder beeinflusst wird.

6. Verfahren nach einem der vorhergehenden Ansprüche, **dadurch gekennzeichnet, dass** die Betriebsweise (SSL 1, SSL 2, SSL 3) betreffend des zugehörigen Energiespeichers (106, 110) sich auf zumindest einen solchen Verbraucher (112, 114) bezieht, der durch den zugehörigen Energiespeicher (106, 110) versorgt wird.

7. Verfahren nach einem der vorhergehenden Ansprüche, **dadurch gekennzeichnet, dass** ein Batteriesensor (10) die Kenngröße desjenigen Energiespeichers (106, 110) prädiziert, dessen typische Kenngrößen dieser Batteriesensor (10) erfasst.

8. Verfahren nach einem der vorhergehenden Ansprüche, **dadurch gekennzeichnet, dass** zur Ermittlung der Kenngröße des Energiespeichers (106, 110) der aktuelle Zustand des Energiespeichers (106, 110) wie beispielsweise Ladezustand (SOC), Temperatur (T), Spannung (U), Strom (I), Innenwiderstand (Ri) verwendet wird.

9. Verfahren nach einem der vorhergehenden Ansprüche, **dadurch gekennzeichnet, dass** das Lastprofil (141, 142, 145, 151) abhängig von zumindest einem Fehler im Bordnetz (100) oder bei einem Verbraucher (112, 114) verändert wird.

10. Verfahren nach einem der vorhergehenden Ansprüche, **dadurch gekennzeichnet, dass** das Lastprofil (141, 142, 145, 151) abhängig von zumindest einem Lastzustand im Bordnetz (100) verändert wird.

11. Verfahren nach einem der vorhergehenden Ansprüche, **dadurch gekennzeichnet, dass** zumindest eine Information für zumindest eine Betriebsweise (SSL1, SSL2, SSL3) abgespeichert wird, ob diese Betriebsweise (SSL1, SSL2, SSL3) verwendet werden kann, das Fahrzeug in einen sicheren Zustand, insbesondere zum Stillstand, zu bringen.

12. Verfahren nach einem der vorhergehenden Ansprüche, **dadurch gekennzeichnet, dass** in einem kritischen Zustand, in dem das Fahrzeug zum Stillstand gebracht werden muss, eine solche Betriebsweise (SSL 1, SSL 2, SSL 3) ausgewählt wird, die bei einer vorherigen Überprüfung auf Basis des Lastprofils (141, 142, 145, 151) als hierfür geeignet ermittelt wurde.

13. Verfahren nach einem der vorhergehenden Ansprüche, **dadurch gekennzeichnet, dass** die Kenngröße der Batterie (106, 110) mit zumindest einem Grenzwert verglichen wird und abhängig von dem Vergleich mit dem Grenzwert die zugehörige Betriebsweise und/oder automatisierte Fahrfunktionen freigegeben, gesperrt, verlassen oder beeinflusst wird.

14. Vorrichtung ausgelegt zur Durchführung eines Verfahrens nach einem der vorhergehenden Ansprüche, umfassend zumindest einen Batteriesensor (10), der geeignet ist, zumindest eine Kenngröße des Energiespeichers (106, 110) zu prädizieren.

## Claims

1. Method for monitoring a motor vehicle with an automated driving function, with different operating modes (SSL1, SSL2, SSL3) for bringing the motor vehicle to a standstill, wherein at least one energy store (106, 110), in particular a battery, supplies at least one consumer (112, 114) which can bring the vehicle to a standstill, **characterized in that** the respective operating mode (SSL1, SSL2, SSL3) is respectively assigned a load profile (141, 142, 145, 151) which usually occurs when controlling the consumer (114, 116) in this operating mode (SSL1, SSL2, SSL3), and **in that** at least one characteristic variable of the energy store (106, 110) is predicted on the basis of at least one of the load profiles (141, 142, 145, 151), and the operating mode (SSL1, SSL2, SSL3) associated with the load profile (141, 142, 145, 151) and/or the automated driving function is/are enabled, blocked, left or influenced on the basis of the predicted characteristic variable of the energy store (106, 110).

2. Method according to Claim 1, **characterized in that** at least two energy stores (106, 110), in particular batteries, are provided for the purpose of supplying, in particular redundantly supplying, the consumer (112, 114) and/or for the purpose of supplying a further consumer (112, 114) which can bring the vehicle to a standstill, and **in that** characteristic variables for each of the two energy stores (106, 110) are predicted on the basis of the load profile (141, 142, 145, 151), wherein the associated operating mode (SSL1, SSL2, SSL3) and/or automated driving function is/are enabled, blocked, left or influenced on the basis of the characteristic variables.

3. Method according to one of the preceding claims, **characterized in that** the load profile (141, 142, 145, 151) is specified on the basis of the state of the vehicle electrical system (100), in particular a fault and/or a load of the vehicle electrical system (100), and/or a state of the load (112, 114).

4. Method according to one of the preceding claims, **characterized in that** the characteristic variable of the energy store (106, 110) is determined on the basis of a model (24) of the energy store (106, 110) that is preferably stored in a battery sensor (10).

5. Method according to one of the preceding claims, **characterized in that** a characteristic variable of a further energy store (106, 110) is predicted on the basis of a model (24) of the further energy store (106, 110), and the operating mode (SSL1, SSL2, SSL3) associated with the load profile (141, 142, 145, 151) and/or the automated driving function is/are enabled, blocked, left or influenced on the basis of the predicted characteristic variable of the further energy store (106, 110).

6. Method according to one of the preceding claims, **characterized in that** the operating mode (SSL1, SSL2, SSL3) relating to the associated energy store (106, 110) relates to at least one such consumer (112, 114) which is supplied by the associated energy store (106, 110).

7. Method according to one of the preceding claims, **characterized in that** a battery sensor (10) predicts the characteristic variable of that energy store (106, 110) whose typical characteristic variables are captured by this battery sensor (10).

8. Method according to one of the preceding claims, **characterized in that** the current state of the energy store (106, 110), for example the state of charge (SOC), temperature (T), voltage (U), current (I), internal resistance (Ri), is used to determine the characteristic variable of the energy store (106, 110).

9. Method according to one of the preceding claims, **characterized in that** the load profile (141, 142, 145, 151) is changed on the basis of at least one fault in the vehicle electrical system (100) or in a consumer (112, 114).

10. Method according to one of the preceding claims, **characterized in that** the load profile (141, 142, 145, 151) is changed on the basis of at least one load state in the vehicle electrical system (100).

11. Method according to one of the preceding claims, **characterized in that** at least one item of information for at least one operating mode (SSL1, SSL2, SSL3) relating to whether this operating mode (SSL1, SSL2, SSL3) can be used to bring the vehicle to a safe state, in particular to a standstill, is stored.

12. Method according to one of the preceding claims, **characterized in that**, in a critical state in which the vehicle must be brought to a standstill, such an operating mode (SSL1, SSL2, SSL3) which was determined as suitable for this purpose in a previous check on the basis of the load profile (141, 142, 145, 151) is selected.

13. Method according to one of the preceding claims, **characterized in that** the characteristic variable of the battery (106, 110) is compared with at least one limit value, and the associated operating mode and/or automated driving functions is/are enabled, blocked, left or influenced on the basis of the comparison with the limit value.

14. Apparatus designed to carry out a method according to one of the preceding claims, comprising at least one battery sensor (10) which is suitable for predicting at least one characteristic variable of the energy store (106, 110).

## Revendications

1. Procédé de surveillance d'un véhicule automobile comprenant une fonction de conduite automatisée, ayant différents modes de fonctionnement (SSL1, SSL2, SSL3), pour amener le véhicule automobile à l'arrêt, au moins un accumulateur d'énergie (106, 110), notamment une batterie, alimentant au moins un récepteur (112, 114) qui peut amener le véhicule automobile à l'arrêt, **caractérisé en ce qu'**un profil de charge (141, 142, 145, 151) est respectivement attribué au mode de fonctionnement (SSL1, SSL2, SSL3) respectif, lequel se produit généralement lors d'une commande du récepteur (114, 116) dans ce mode de fonctionnement (SSL1, SSL2, SSL3), **en ce qu'**au moins une grandeur caractéristique de l'accumulateur d'énergie (106, 110) est prédite en fonction d'au moins un profil de charge (141, 142, 145, 151), et le mode de fonctionnement (SSL1, SSL2, SSL3) associé au profil de charge (141, 142, 145, 151) et/ou la fonction de conduite automatisée sont libérés, bloqués, quittés ou influencés en fonction de la grandeur caractéristique prédite de l'accumulateur d'énergie (106, 110).

2. Procédé selon la revendication 1, **caractérisé en ce qu'**au moins deux accumulateurs d'énergie (106, 110), notamment des batteries, sont présents pour l'alimentation notamment redondante du récepteur (112, 114) et/ou pour l'alimentation d'un récepteur (112, 114) supplémentaire qui peut amener le véhicule automobile à l'arrêt, et **en ce que** des grandeurs caractéristiques sont prédites pour chacun des deux accumulateurs d'énergie (106, 110) en fonction du profil de charge (141, 142, 145, 151), le mode de fonctionnement (SSL1, SSL2, SSL3) associé et/ou la fonction de conduite automatisée étant libérés, bloqués, quittés ou influencés en fonction des grandeurs caractéristiques.

3. Procédé selon l'une des revendications précédentes, **caractérisé en ce que** le profil de charge (141, 142, 145, 151) est prédéfini en fonction de l'état du réseau de bord (100), notamment d'un défaut et/ou d'une charge du réseau de bord (100), et/ou d'un état de la charge (112, 114) .

4. Procédé selon l'une des revendications précédentes, **caractérisé en ce que** la grandeur caractéristique de l'accumulateur d'énergie (106, 110) est déterminée en fonction d'un modèle (24) de l'accumulateur d'énergie (106, 110) qui est de préférence enregistré dans un capteur de batterie (10).

5. Procédé selon l'une des revendications précédentes, **caractérisé en ce que** la grandeur caractéristique d'un accumulateur d'énergie (106, 110) supplémentaire est prédite en fonction d'un modèle (24) de l'accumulateur d'énergie (106, 110) supplémentaire et le mode de fonctionnement (SSL1, SSL2, SSL3) associé au profil de charge (141, 142, 145, 151) et/ou la fonction de conduite automatisée sont libérés, bloqués, quittés ou influencés en fonction des grandeurs caractéristiques prédites de l'accumulateur d'énergie (106, 110) supplémentaire.

6. Procédé selon l'une des revendications précédentes, **caractérisé en ce que** le mode de fonctionnement (SSL1, SSL2, SSL3) concernant l'accumulateur d'énergie (106, 110) associé se rapporte au moins à un récepteur (112, 114) qui est alimenté par l'accumulateur d'énergie (106, 110) associé.

7. Procédé selon l'une des revendications précédentes, **caractérisé en ce qu'**un capteur de batterie (10) prédit la grandeur caractéristique de l'accumulateur d'énergie (106, 110) dont les grandeurs caractéristiques types sont acquises par ce capteur de batterie (10).

8. Procédé selon l'une des revendications précédentes, **caractérisé en ce que** l'état actuel de l'accumulateur d'énergie (106, 110), par exemple l'état de charge (SOC), la température (T), la tension (U), le courant (I), la résistance interne (Ri), est utilisé pour la détermination de la grandeur caractéristique de l'accumulateur d'énergie (106, 110).

9. Procédé selon l'une des revendications précédentes, **caractérisé en ce que** le profil de charge (141, 142, 145, 151) est modifié en fonction d'au moins un défaut dans le réseau de bord (100) ou au niveau d'un récepteur (112, 114) .

10. Procédé selon l'une des revendications précédentes, **caractérisé en ce que** le profil de charge (141, 142, 145, 151) est modifié en fonction d'au moins un état de charge dans le réseau de bord (100).

11. Procédé selon l'une des revendications précédentes, **caractérisé en ce qu'**au moins une information pour au moins un mode de fonctionnement (SSL1, SSL2, SSL3) est enregistrée, laquelle indique si ce mode de fonctionnement (SSL1, SSL2, SSL3) peut être utilisé pour amener le véhicule dans un état sécurisé, notamment à l'arrêt.

12. Procédé selon l'une des revendications précédentes, **caractérisé en ce que** dans un état critique, dans lequel le véhicule doit être amené à l'arrêt, le mode de fonctionnement (SSL1, SSL2, SSL3) sélectionné est un mode de fonctionnement qui a été déterminé comme étant approprié à cet effet lors d'un contrôle précédent sur la base du profil de charge (141, 142, 145, 151).

13. Procédé selon l'une des revendications précédentes, **caractérisé en ce que** la grandeur caractéristique de la batterie (106, 110) est comparée à au moins une valeur limite et le mode de fonctionnement associé et/ou les fonctions de conduite automatisées sont libérés, bloqués, quittés ou influencés en fonction de la comparaison avec la valeur limite.

14. Dispositif conçu pour mettre en œuvre un procédé selon l'une des revendications précédentes, comprenant au moins un capteur de batterie (10) qui est adapté pour prédire au moins une grandeur caractéristique de l'accumulateur d'énergie (106, 110).
